# EUROPEAN PATENT APPLICATION

(11) **EP 4 521 472 A1**
(43) Date of publication of application: **12.03.2025**
(21) Application number: 24165893.9
(22) Date of filing: 25.03.2024
(51) Int. Cl.: H01L 31/102, H01L 31/0224

(54) **LIGHT SENSOR AND MANUFACTURING METHOD THEREOF**

(30) Priority: 06.09.2023 TW 112133829; 16.11.2023 TW 112144389
(71) Applicant: National Taiwan University of Science and Technology, Taipei (TW)
(72) Inventor: CHEN, Ruei-San, TAIPEI CITY (TW); WANG, Jyh-Shyang, TAOYUAN CITY (TW)
(74) Representative: Cabinet Beaumont

(57) **Abstract**

A light sensor includes a lower electrode layer, an absorption layer and an upper electrode layer. The absorption layer is located on the lower electrode layer, in which the absorption layer includes a material that has an electron mobility greater than 300 cm²/Vs and greater than twice as many as a hole mobility. The upper electrode layer is located on the absorption layer, and is configured to collect the scattered high-speed excess electrons and to leave low-speed excess holes near the edges of the upper electrode layer. A downward photocurrent is generated by the photovoltage in the absorption layer due to the formation of positively charged region near the upper surface.

## Description

### BACKGROUND

### Field of Invention

The present disclosure relates to a light sensor and a manufacturing method of a light sensor.

### Description of Related Art

In the field of far infrared (FIR) detection, infrared detectors can be divided into two types. One is the detector that can operate at room temperature; the other is the refrigerated detectors. Generally, the detectors that operate at room temperature have a lower signal detectivity and a lower image resolution, and cannot provide a more precise measurement. Only the refrigerated detectors can offer a higher detectivity and resolution.

However, the non-refrigerated detectors mentioned above suffer high dark current level and thermal noise. To improve signal-to-noise ratio, the FIR detectors are preferentially operated at the temperature of liquid nitrogen or with thermoelectric cooling, which result in a significantly high fabrication and operation costs of such type of detector. Also, since the volume of the cooling system is generally larger than the volume of the detector, such detector is hard to dispose.

### SUMMARY

One aspect of the present disclosure provides a light sensor.

According to one embodiment of the present disclosure, a light sensor includes a lower electrode layer, an absorption layer and an upper electrode layer. The absorption layer is located on the lower electrode layer, in which the absorption layer includes a material that has an electron mobility greater than 300 cm²/Vs and greater than twice as many as a hole mobility, the absorption layer is configured to generate a photocurrent through a difference between the electron mobility and the hole mobility. The upper electrode layer is located on the absorption layer and is configured to collect electrons in the photocurrent.

In some embodiments of the present disclosure, the absorption layer includes a semiconductor-semiconductor junction with a downward built-in electric field, a semiconductor-semimetal junction with a downward built-in electric field, a semimetal-semimetal junction with a downward built-in electric field or a combination thereof.

In some embodiments of the present disclosure, a top view shape of the upper electrode layer is at least one of a comb shape, a tree shape, a mesh shape or a helical shape, and the upper electrode layer and the absorption layer form an Ohmic contact or a Schottky contact.

In some embodiments of the present disclosure, the upper electrode layer is located in a trench of the absorption layer.

In some embodiments of the present disclosure, the light sensor further includes a substrate and a buffer layer. The substrate is located between the absorption layer and the lower electrode layer. The buffer layer is located between the substrate and the absorption layer.

In some embodiments of the present disclosure, a top view shape of the upper electrode layer is a rectangle, and the upper electrode layer is a transparent conductive film includes indium tin oxide (ITO) or aluminum zinc oxide (AZO).

In some embodiments of the present disclosure, the light sensor further includes a capping layer. The capping layer is located on the absorption layer and surrounds the upper electrode layer.

Another aspect of the present disclosure provides a manufacturing method of a light sensor.

According to one embodiment of the present disclosure, a manufacturing method of a light sensor includes providing an absorption layer, in which the absorption layer includes a material that has an electron mobility greater than 300 cm²/Vs and greater than twice as many as a hole mobility, the absorption layer is configured to generate a photovoltage and a photocurrent through a difference between the electron mobility and the hole mobility; plating an upper electrode layer on the absorption layer, in which the upper electrode layer is configured to collect photogenerated electrons with higher thermal speed and longer collision length compared with photogenerated holes, to destroy electrical neutrality at the region of absorption later close to the upper electrode layer and to cause a positive charge accumulation of excess holes to generate a photovoltage; and forming a lower electrode layer, such that the absorption layer is located between the upper electrode layer and the lower electrode layer.

In some embodiments of the present disclosure, providing the absorption layer includes forming the absorption layer on a substrate.

In some embodiments of the present disclosure, forming the lower electrode layer includes forming the lower electrode layer on a surface facing away the absorption layer on the substrate, such that the lower electrode layer and the substrate form an Ohmic contact or a Schottky contact.

In some embodiments of the present disclosure, forming the absorption layer on the substrate includes forming the absorption layer by at least one of molecular beam epitaxy (MBE), chemical vapor deposition (CVD), physical vapor deposition (PVD), atomic layer deposition (ALD), liquid phase epitaxy (LPE), diffusion or ion implantation.

In some embodiments of the present disclosure, the manufacturing method of the light sensor further includes forming a trench on the absorption layer, in which a top view shape of the trench is at least one of a comb shape, a tree shape, a mesh shape or a helical shape; and plating an upper electrode layer in the trench, such that the upper electrode layer and the absorption layer form an Ohmic contact or a Schottky contact.

In some embodiments of the present disclosure, the manufacturing method of the light sensor further includes forming a buffer layer on the substrate; and forming the absorption layer on the buffer layer.

In some embodiments of the present disclosure, the manufacturing method of the light sensor further includes forming a capping layer on the absorption layer; patterning the capping layer to form an opening exposing the absorption layer; and plating the upper electrode layer in the opening.

In some embodiments of the present disclosure, plating the upper electrode layer on the absorption layer, such that the upper electrode layer and the absorption layer form an Ohmic contact or a Schottky contact.

In the aforementioned embodiments of the present disclosure, since the absorption layer includes a material that has the electron mobility greater than twice as many as its hole mobility, a photocurrent can be generated using the difference between the electron mobility and the hole mobility, and the light sensor can operate independently without the assistance of the cooling system. Also, the light sensor can operate without bias and can provide FIR detection with high detectivity.

It is to be understood that both the foregoing general description and the following detailed description are by examples, and are intended to provide further explanation of the invention as claimed.

### BRIEF DESCRIPTION OF THE DRAWINGS

The invention can be more fully understood by reading the following detailed description of the embodiments, with reference made to the accompanying drawings as follows:
Fig. 1 is a cross-sectional view of a light sensor according to one embodiment of the present disclosure.
Fig. 2 is a cross-sectional view of a light sensor according to another embodiment of the present disclosure.
Fig. 3 is a stereogram of a light sensor according to yet another embodiment of the present disclosure.
Fig. 4 is a stereogram of a light sensor according to yet another embodiment of the present disclosure.
Fig. 5 is a stereogram of a light sensor according to yet another embodiment of the present disclosure.
Fig. 6 is a cross-sectional view of a light sensor according to yet another embodiment of the present disclosure.
Fig. 7 is a flow chart of a manufacturing method of a light sensor according to one embodiment of the present disclosure.

### DETAILED DESCRIPTION

Reference will now be made in detail to the present embodiments of the invention, examples of which are illustrated in the accompanying drawings. Wherever possible, the same reference numbers are used in the drawings and the description to refer to the same or like parts.

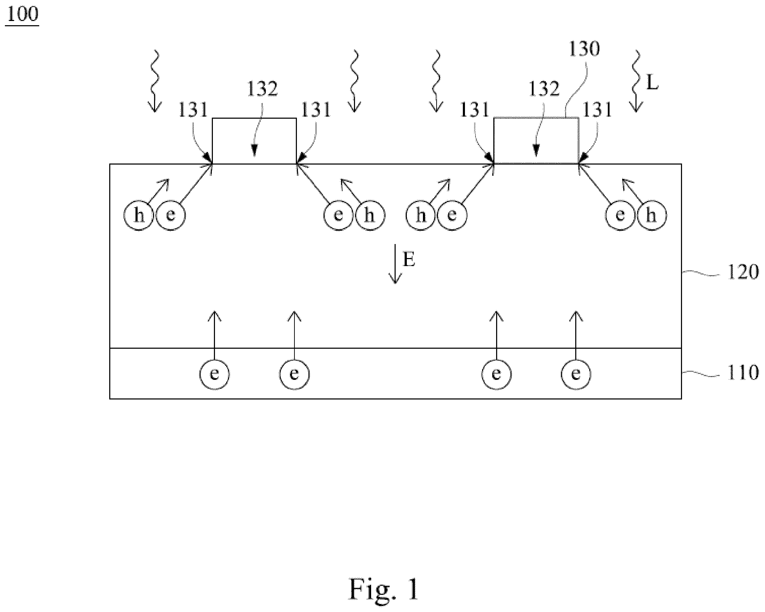

Fig. 1 is a cross-sectional view of a light sensor 100 according to one embodiment of the present disclosure. Refer to Fig. 1, a light sensor 100 includes a lower electrode layer 110, an absorption layer 120 and an upper electrode layer 130. The absorption layer 120 is located on the lower electrode layer 110, in which the absorption layer 120 includes a material that has an electron mobility greater than 300 cm²/Vs and greater than twice as many as a hole mobility, the absorption layer 120 is configured to generate a photocurrent through a difference between the electron mobility and the hole mobility. The upper electrode layer 130 is located on the absorption layer 120 and is configured to collect electrons e in the photocurrent. When a semiconductor material or a semimetal material (such as the absorption layer 120) is excited by a light L, pairs of electron-hole will form. Here, since some materials (which will be described later) has a significantly high electron mobility and a great difference between the electron mobility and the hole mobility, the electrons scatter and diffuse in a speed far faster than the holes. When the electron-hole pairs are generated by light irradiation at the peripheral of the upper electrode layer 130, such as the boarder 131 of the upper electrode layer 130 and the interface 132 between the upper electrode layer 130 and the absorption layer 120, the fast electrons, such as the electrons e on the upper part of Fig. 1, will enter the upper electrode layer 130 and leave the holes with slow velocity. These holes with their electrons deprived form a positive charge at the peripheral of the upper electrode layer 130. A vertically downward electric field E is then generated in the light sensor 100 between the peripheral of the upper electrode layer 130 and the lower electrode layer 110 without irradiation, which pushes the carriers in the absorption layer 120 to flow and to generate a photocurrent. The representative materials that has a significantly high electron mobility and a great difference between the electron mobility and the hole mobility includes indium arsenide (InAs), indium antimonide (InSb), indium phosphide (InP), gallium arsenide (GaAs), gallium antimonide (GaSb), indium gallium arsenide (In_{0.53}Ga_{0.47}As), mercury cadmium telluride (Hg₁₋ₓCdₓTe), cadmium arsenide (Cd₃As₂), a combination thereof, an alloy thereof or other suitable materials. Table 1 shows the electron mobility and the hole mobility of the materials mentioned above under room temperature:

**Table 1**

| material | Electron mobility (cm²/Vs) | Hole mobility (cm²/Vs) |
|---|---|---|
| InAs | 30000 | 200 |
| InSb | 80000 | 800 |
| InP | 4000 | 100 |
| GaAs | 8500 | 400 |
| GaSb | 5000 | 1000 |
| In_{0.53}Ga_{0.47}As | 13800 | 500 |
| Hg₁₋ₓCdₓTe | 10000 | 100 |
| Cd₃As₂ | 15000 | 500 |

It can be see that the materials mentioned above has a significantly great difference between the electron mobility and the hole mobility. The electron mobility of such materials is at least twice as many as the hole mobility, even an a hundred times difference is in the case of indium antimonide, which can be used as the absorption layer 120 of the light sensor 100. The lower electrode layer 110 is configured to provide electrons to form a complete circuit in the light sensor 100. Theoretically the absorption layer with higher electron mobility and higher ratio of electron mobility to hole mobility provide better detector performance in this design. The electron mobility value set at 300 cm²/Vs and the ratio set at two are empirical.

In some embodiments, Ohmic contact is formed between the upper electrode layer 130 and the absorption layer 120. In some embodiments, Ohmic contact is formed between the absorption layer 120 and the lower electrode layer 110. The Ohmic contacts between the upper electrode layer 130 and the absorption layer 120 and between the absorption layer 120 and the lower electrode layer 110 can enhance the electron collection efficiency in the light sensor 100. The resistance of the light sensor 100 can be decreased and the photocurrent can be increase through moderate P doping in the absorption layer 120, which can achieve a higher detectivity and a higher sensitivity. The moderate P doping can also prevent the absorption layer 120 from a loss of the positive photocurrent (towards the lower electrode layer 110) caused by the reversed thermoelectric current (towards the upper electrode layer 130) generated when the absorption layer 120 is irradiated and the reversed photocurrent (towards the upper electrode layer 130) generated by Schottky contact under the condition that the absorption layer 120 is a N-type semiconductor.

Apart from the manufacturing method with Ohmic contact mentioned above, a Schottky contact can also formed between the upper electrode layer 130 and the absorption layer 120. Since a P-type semiconductor is used in the absorption layer 120 in general, when the Schottky contact is formed between the P-type semiconductor and the metal of the upper electrode layer 130, the direction of the internal electric field will be directed toward the absorption layer 120. Such internal electric field will accelerate and push the photogenerated electrons into the metal side and prevent the photogenerated holes from entering the upper electrode layer 130 when the electron-hole pairs are generated after irradiation. Such design can reduce the obstruction effect of the contact resistance of the light sensor 100 on the photogenerated electron and increase the probability for the photogenerated electron to enter the upper electrode layer 130 when a perfect Ohmic contact is difficult to manufacture. However, such design is not suitable for the interface between the lower electrode layer 110 and the absorption layer 120. The interface between the lower electrode layer 110 and the absorption layer 120 is mainly an Ohmic contact. Unless the total resistance of the light sensor 100 is too small, methods to increase resistance such as Schottky contact or an additional blocking layer can also be used to increase the total resistance of the light sensor 100 and to reduce thermal noise.

Since the absorption layer 120 of the light sensor 100 includes a material that has the electron mobility greater than twice as many as its hole mobility, a photocurrent can be generate using the difference between the electron mobility and the hole mobility, and the light sensor can operate independently without the assistance of the cooling system. Also, the light sensor can operate without bias which can provide very low dark current is especially important and suitable for FIR detection with high detectivity and high resolution. Though the light sensor can operate at zero bias, an external bias can still be applied to balance the background or leakage voltage in the sensor and its circuits.

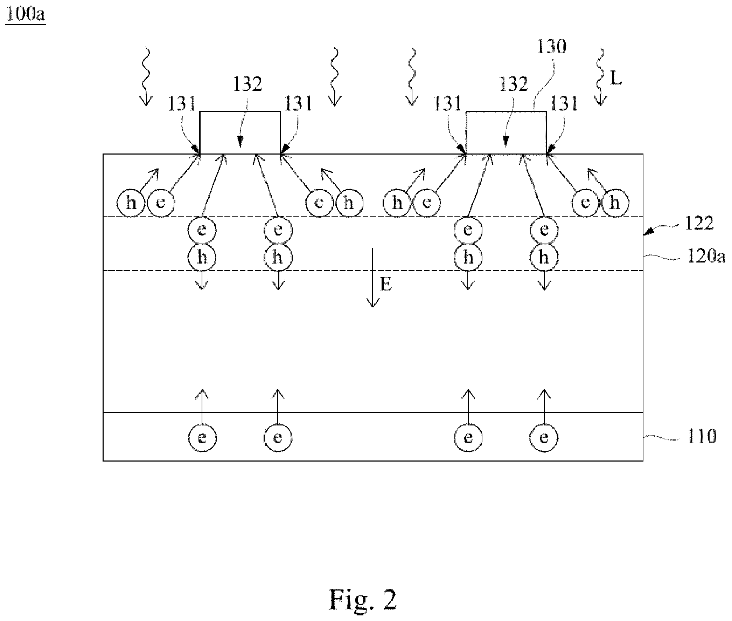

Fig. 2 is a cross-sectional view of a light sensor 100a according to another embodiment of the present disclosure. Refer to Fig. 2, the material of the absorption layer 120a can be a single material. Also the material of the absorption layer 120a can be junction area 122 that includes a semiconductor-semiconductor junction, a semiconductor-semimetal junction, or a semimetal-semimetal junction with an internal downward electric field in the area near the upper surface of the absorption layer 120a. The junction area 122 can be a NP junction, a NIP junction, an IP junction, a P⁻P junction or a PP⁺ junction, but not limited to these. The purpose of the junction area 122 is to form electron-hole separation after irradiation, such that this layer can also be referred to as an electron-hole separation layer. Thereafter, the fast electrons will enter the upper electrode layer 130 on the upper surface. Therefore, aside from the holes adjacent to the boarder 131 and the interface 132 of the upper electrode layer 130, such as the holes h in Fig. 1 or the holes h on the upper side of Fig. 2, the additional holes generated by the junction area 122 (the holes h on the lower side of Fig. 2) can further increase the amount of positive charge, which further enhance the vertical downward electric field E and the photocurrent in the absorption layer 120 after irradiation.

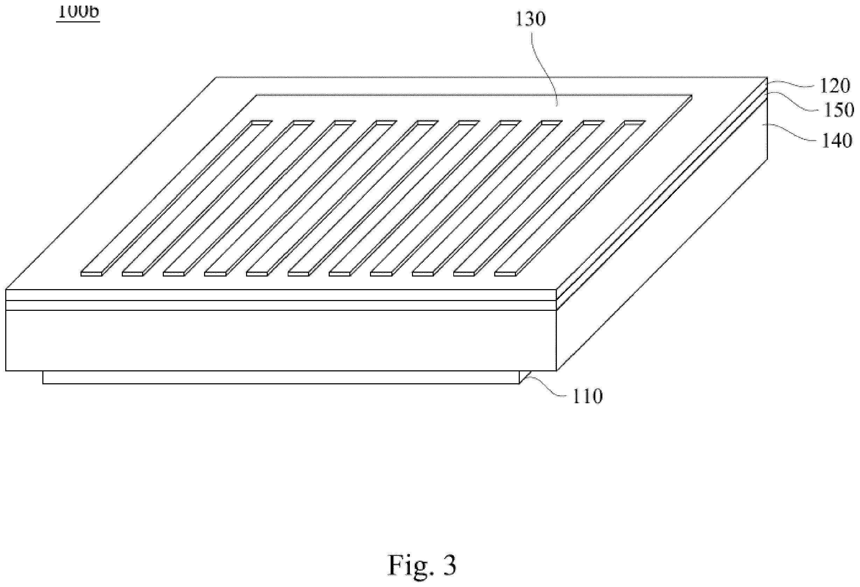

Fig. 3 is a stereogram of a light sensor 100b according to yet another embodiment of the present disclosure. Refer to Fig. 3, the light sensor 100b further includes a substrate 140. The substrate 140 is located between the absorption layer 120 and the lower electrode layer 110. In the present embodiment, a top view shape of the upper electrode layer 130 is a comb shape. The reason of such shape is that the electron collection efficiency at the edge of the upper electrode layer 130 (see Fig. 1) is the best, which can produce the strongest electric field E (see Fig. 1). Therefore, The length of the edge of the comb-shaped part of the upper electrode layer 130 can be lengthen in a limited area through designing the top view shape of the upper electrode layer 130 to be comb shape. In some embodiments, the top view shape of the upper electrode layer can also be a tree shape, a mesh shape or a helical shape, but the disclosure is not limited to this. In some embodiments, the light sensor 100b further includes a buffer layer 150. The buffer layer 150 is located between the substrate 140 and the absorption layer 120. If the lattice between the material of the absorption layer 120 and the material of the substrate 140 is not matched, a buffer layer 150 can be added to solve the problem. The material of the buffer layer 150 can include cadmium zinc telluride (CdZnTe), but the disclosure is not limited to this.

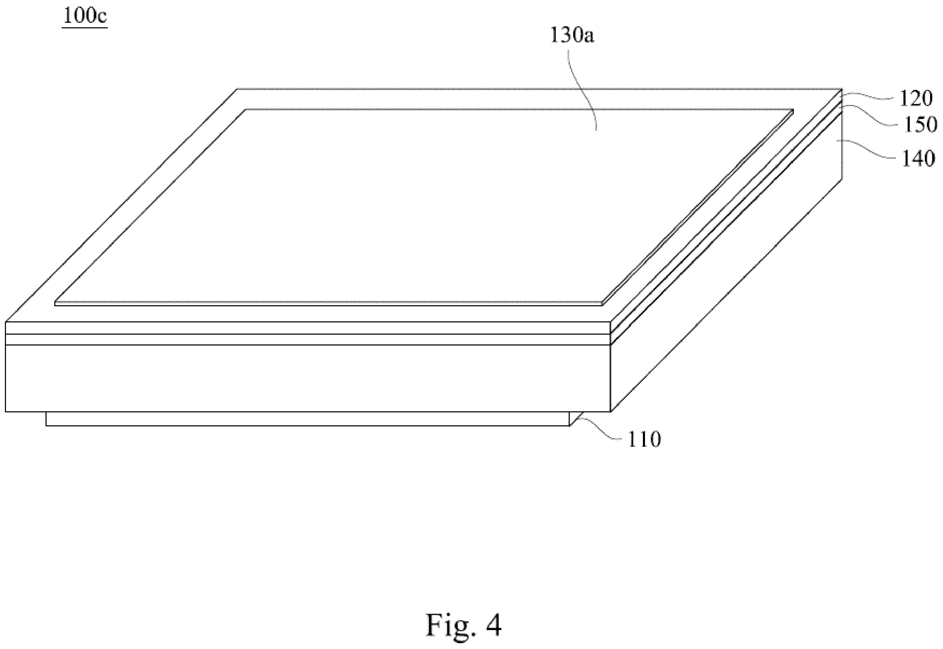

Fig. 4 is a stereogram of a light sensor 100c according to yet another embodiment of the present disclosure. Refer to Fig. 4, a light sensor 100c includes a lower electrode layer 110, an absorption layer 120, an upper electrode layer 130a, a substrate 140 and a buffer layer 150. The difference between the present embodiment and the embodiment of Fig. 3 is that, in the present embodiment, a top view shape of the upper electrode layer 130a is a rectangle, and the material of the upper electrode layer 130a is a transparent conductive film includes indium tin oxide (ITO) or aluminum zinc oxide (AZO) for UV, visible, and NIR light detections, but the disclosure is not limited to this. In the present embodiment, the whole part of the upper electrode layer 130a that is made of transparent conductive material can be used to be the area to collect photogenerated electrons. Since the upper electrode layer 130a includes transparent conductive material, the absorption layer underneath can be irradiated. The photogenerated electrons that are excited after irradiation are then collected by the upper electrode layer 130a can generate a photocurrent.

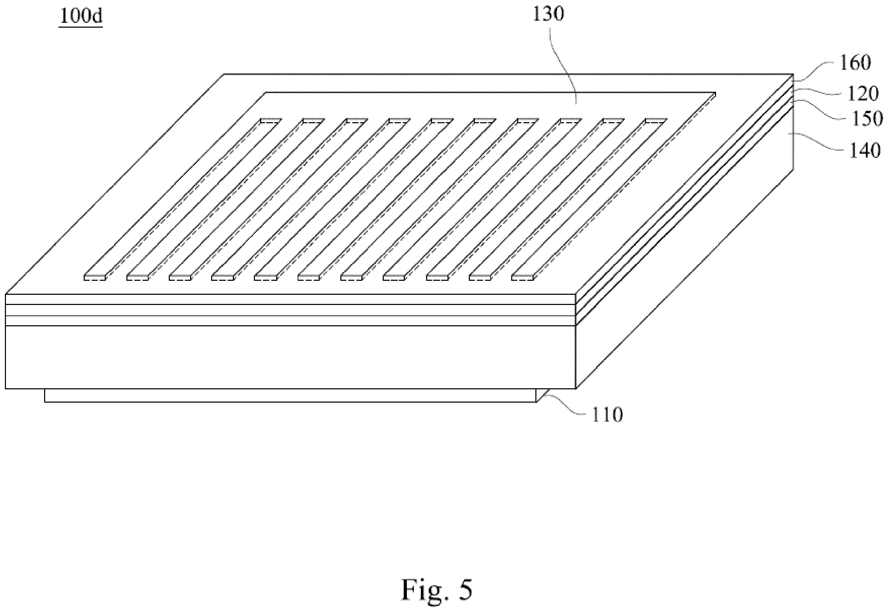

Fig. 5 is a stereogram of a light sensor 100d according to yet another embodiment of the present disclosure. Refer to Fig. 5, a light sensor 100d includes a lower electrode layer 110, an absorption layer 120, an upper electrode layer 130, a substrate 140 and a buffer layer 150. The difference between the present embodiment and the embodiment of Fig. 3 is that, in the present embodiment, the light sensor 100d further includes a capping layer 160. The capping layer 160 is located on the absorption layer 120 and surrounds the upper electrode layer 130. The capping layer 160 is configured to prevent the surface of the material of the absorption layer 120 from directly contacting the air and reduce the defect density of the surface of the absorption layer 120. The material of the capping layer 160 can include cadmium zinc telluride (CdZnTe), but the disclosure is not limited to this.

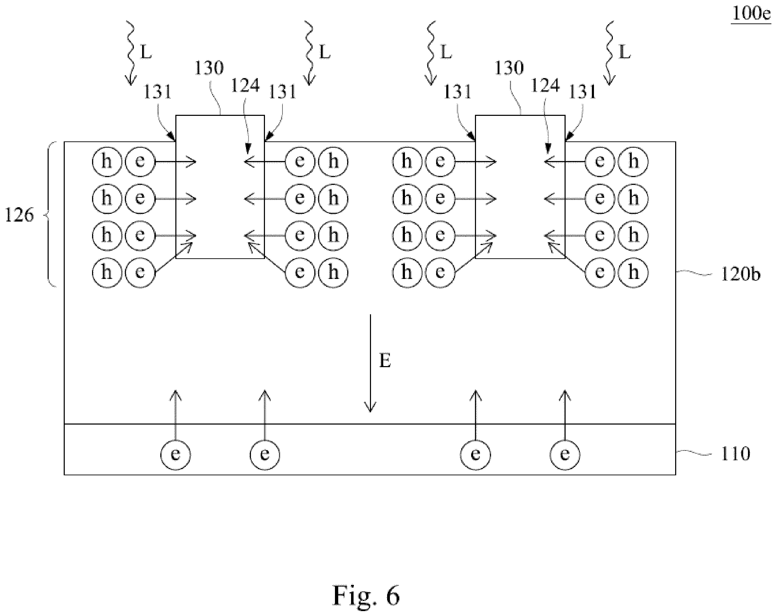

Fig. 6 is a cross-sectional view of a light sensor 100e according to yet another embodiment of the present disclosure. Refer to Fig. 6, a light sensor 100e includes a lower electrode layer 110, an absorption layer 120b and an upper electrode layer 130. The absorption layer 120 is located on the lower electrode layer 110. The upper electrode layer 130 is located on the absorption layer 120 and is configured to collect electrons e in the photocurrent. The difference between the present embodiment and the embodiment of Fig. 1 is that, in the present embodiment, the absorption layer has a trench 124, and part of the upper electrode layer 130 is located in the trench 124. Since the physical mechanism that the photogenerated electrons enter the upper electrode layer 130 is spontaneous thermal scattering and the amount of the photoelectrons that enters the upper electrode layer 130 is decided by the mean collision length. If the mean collision length is greater, the amount of scattering photogenerated electrons that can enter the upper electrode layer 130 is more. However, the mean collision length of the electrons are generally less than 1 micrometer, which cause that the positive charge creation area (active area, or where electron-hole pairs are created) is shallow. Under the condition that the penetration depth of the light in the absorption layer is generally greater than 1 micrometer, the quantum efficiency in the light sensor is then decreased. Therefore, a trench with the shape of the upper electrode layer 130 can be formed in the absorption layer 120b through etching or other method, and then fill a metal or conductive material into the trench 124. In this way, the range that the electrons can be collected is not limited to the peripheral of the upper electrode layer 130 adjacent to the surface, such as the boarder 131 of the upper electrode layer of Fig. 1, but it can be increased as the depth of the upper electrode layer 130 increase (such as the depth of the light-induced positive charge area 126).

The electrode 130 in the trenches 124 of Fig. 6 can be selectively implemented in the embodiments of Fig. 2, Fig. 3 and Fig. 5.

It is to be noted that the connection relationship of the aforementioned elements will not be repeated. In the following description, a manufacturing method of a light sensor is described.

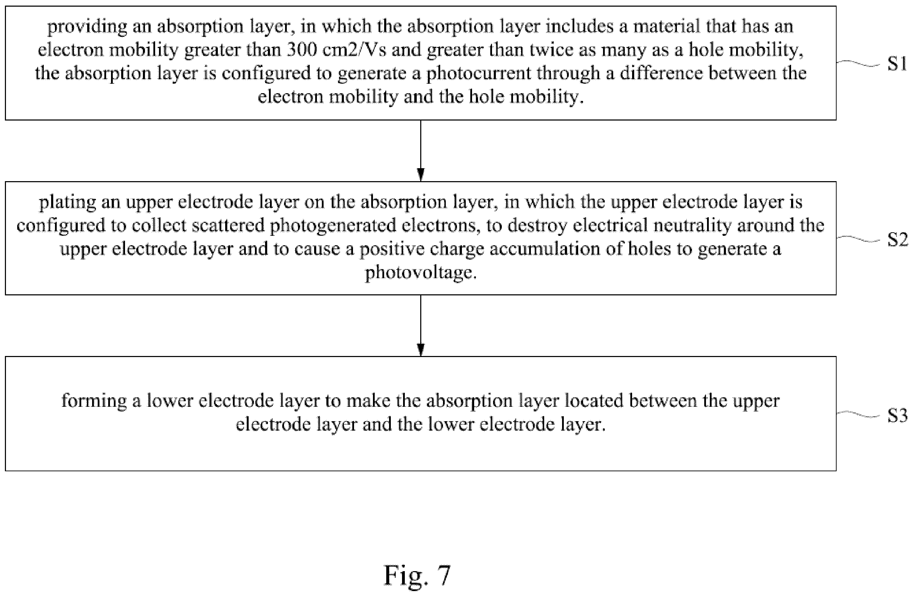

Fig. 7 is a flow chart of a manufacturing method of a light sensor according to one embodiment of the present disclosure. Refer to Fig. 7, a manufacturing method of a light sensor includes the following steps: First in step S1, providing an absorption layer, in which the absorption layer includes a material that has an electron mobility greater than 300 cm2/Vs and greater than twice as many as a hole mobility, the absorption layer is configured to generate a photocurrent through a difference between the electron mobility and the hole mobility. Then in step S2, plating an upper electrode layer on the absorption layer, in which the upper electrode layer is configured to collect scattered photogenerated electrons, to destroy electrical neutrality around the upper electrode layer and to cause a positive charge accumulation of holes to generate a photovoltage. Finally in step S3, forming a lower electrode layer, such that the absorption layer located between the upper electrode layer and the lower electrode layer.

In some embodiments, the manufacturing method of the light sensor is not limited to the steps S1 to S3 mentioned above. For example, each of the steps S1 to S3 can includes other detailed steps. In some embodiments, other steps can be further included between two steps of the steps S1 to S3, before step S1, or after step S3. Or else, some steps of step S1 to Step S3 can be repeated. In the following description, at least the above mentioned steps will be described in detail.

Refer to Fig. 3, in the embodiment of Fig. 3, before forming the absorption layer 120 on the substrate 140, a buffer layer 150 is formed on the substrate 140. Thereafter, forming the absorption layer 120. Forming the absorption layer on the substrate includes using molecular beam epitaxy (MBE), chemical vapor deposition (CVD), physical vapor deposition (PVD), atomic layer deposition (ALD), liquid phase epitaxy (LPE), a combination thereof or other suitable method. Or, in other embodiments, the buffer layer 150 can be ignored, and the absorption layer 120 can be form in the substrate through diffusion or ion implantation, but the disclosure is not limited to this. Forming the absorption layer 120 through diffusion or ion implantation can form the absorption layer 120a as the embodiment of Fig. 2 that has a junction area. The absorption layer 120 can be doped through diffusion or ion implantation.

In some embodiments (such as the embodiment of Fig. 5), thereafter, forming a capping layer 160 on the absorption layer 120; thereafter, patterning the capping layer 160 to form an opening that exposed the absorption layer 120; and plating the upper electrode layer 130 in the opening on the absorption layer 120. When the shape of the opening of the capping layer 160 mentioned above is comb-shaped, plating the upper electrode layer 130 in the opening on the absorption layer 120 can make the top view shape of the upper electrode layer 130 a comb shape, and an Ohmic contact or a Schottky contact is formed between the upper electrode layer 130 and the absorption layer 120. In other embodiments, the capping layer 160 can be ignored and the upper electrode layer 130 (the embodiment of Fig. 3) or 130a (the embodiment of Fig. 4) is directly formed.

Thereafter, forming a lower electrode layer 110, such that the absorption layer 120 located between the upper electrode layer 130 and the lower electrode layer 110. In some embodiments, such as the embodiment of Fig. 1, the lower electrode layer 110 is located on the surface facing away the upper electrode layer 130 of the absorption layer 120. In some embodiments, such as the embodiment of Fig. 3, the lower electrode layer 110 is located on the surface facing away the absorption layer 120 of the substrate 140. The step can form an Ohmic contact between the lower electrode layer 110 and the absorption layer 120, or between the lower electrode layer 110 and the substrate 140. The lower electrode layer 110 is distributed uniformly different from the upper electrode layer 130.

## Claims

1. A light sensor, comprising:
a lower electrode layer (110);
an absorption layer (120) located on the lower electrode layer (110), wherein the absorption layer (120) comprises a material that has an electron mobility greater than 300 cm²/Vs and greater than twice as many as a hole mobility, the absorption layer (120) is configured to generate a photocurrent through a difference between the electron mobility and the hole mobility; and
an upper electrode layer (130) located on the absorption layer (120), configured to collect electrons (e) in the photocurrent.

2. The light sensor of claim 1, wherein the absorption layer (120) comprises a semiconductor-semiconductor junction (122) with a downward built-in electric field, a semiconductor-semimetal junction (122) with a downward built-in electric field, a semimetal-semimetal junction (122) with a downward built-in electric field or a combination thereof.

3. The light sensor of claim 1 or 2, wherein a top view shape of the upper electrode layer (130) is at least one of a comb shape, a tree shape, a mesh shape or a helical shape, and the upper electrode layer (130) and the absorption layer (120) form an Ohmic contact or a Schottky contact.

4. The light sensor of claim 3, wherein the upper electrode layer (130) is located in a trench (124) of the absorption layer (120).

5. The light sensor of any one of claims 1-4, further comprising:
a substrate (140) located between the absorption layer (120) and the lower electrode layer (110); and
a buffer layer (150) located between the substrate (140) and the absorption layer (120).

6. The light sensor of any one of claims 1 to 5, wherein a top view shape of the upper electrode layer (130a) is a rectangle, and the upper electrode layer (130a) is a transparent conductive film comprises indium tin oxide (ITO) or aluminum zinc oxide (AZO).

7. The light sensor of any one of claims 1 to 6, further comprising:
a capping layer (160) located on the absorption layer (120) and surrounding the upper electrode layer (130).

8. A manufacturing method of a light sensor, comprising:
providing an absorption layer (120), wherein the absorption layer (120) comprises a material that has an electron mobility greater than 300 cm²/Vs and greater than twice as many as a hole mobility, the absorption layer (120) is configured to generate a photocurrent through a difference between the electron mobility and the hole mobility;
plating an upper electrode layer (130) on the absorption layer (120), wherein the upper electrode layer (130) is configured to collect scattered photogenerated electrons, to destroy electrical neutrality around the upper electrode layer (130) and to cause a positive charge accumulation of holes to generate a photovoltage; and
forming a lower electrode layer (110), such that the absorption layer (120) is located between the upper electrode layer (130) and the lower electrode layer (110).

9. The manufacturing method of the light sensor of claim 8, wherein providing the absorption layer (120) comprises:
forming the absorption layer (120) on a substrate (140).

10. The manufacturing method of the light sensor of claim 9, wherein forming the lower electrode layer (110) comprises:
forming the lower electrode layer (110) on a surface facing away the absorption layer (120) on the substrate (140), such that the lower electrode layer (110) and the substrate (140) form an Ohmic contact or a Schottky contact.

11. The manufacturing method of the light sensor of claim 9, wherein forming the absorption layer (120) on the substrate (140) comprises forming the absorption layer (120) by at least one of a molecular beam epitaxy (MBE), a chemical vapor deposition (CVD), a physical vapor deposition (PVD), an atomic layer deposition (ALD), a liquid phase epitaxy (LPE), a diffusion or an ion implantation.

12. The manufacturing method of the light sensor of any one of claims 8 to 11, further comprising:
forming a trench (124) on the absorption layer (120), wherein a top view shape of the trench (124) is at least one of a comb shape, a tree shape, a mesh shape or a helical shape; and
plating an upper electrode layer (130) in the trench (124), such that the upper electrode layer (130) and the absorption layer (120) form an Ohmic contact or a Schottky contact.

13. The manufacturing method of the light sensor of any one of claims 8 to 12, further comprising:
forming a buffer layer (150) on a substrate (140); and
forming the absorption layer (120) on the buffer layer (150).

14. The manufacturing method of the light sensor of any one of claims 8 to 13, further comprising:
forming a capping layer (160) on the absorption layer (120);
patterning the capping layer (160) to form an opening exposing the absorption layer (120); and
plating the upper electrode layer (130) in the opening.

15. The manufacturing method of the light sensor of any one of claims 8 to 14, wherein plating the upper electrode layer (130) on the absorption layer (120), such that the upper electrode layer (130) and the absorption layer (120) form an Ohmic contact or a Schottky contact.
